# EUROPEAN PATENT APPLICATION

(11) **EP 4 707 841 A2**
(43) Date of publication of application: **11.03.2026**
(21) Application number: 25199798.7
(22) Date of filing: 03.09.2025
(51) Int. Cl.: G01R 33/26

(54) **OPTICALLY PUMPED MAGNETOMETER**

(30) Priority: 04.09.2024 FI 20246091
(71) Applicant: Megin Oy, 02150 Espoo (FI)
(72) Inventor: Zetter, Rasmus, 02150 Espoo (FI); Kamppinen, Timo, 02150 Espoo (FI); Frilund, Patrick, 02150 Espoo (FI); Laine, Petteri, 02150 Espoo (FI)
(74) Representative: Papula Oy

(57) **Abstract**

An optically pumped magnetometer comprises a vapor cell for optical pumping, a light source arranged for optically pumping the vapor cell, a photosensitive device arranged for sensing light from the vapor cell and a circuit board construction comprising two or more planar regions coupled to each other through one or more flexible regions, the two or more planar regions comprising a first planar region and a second planar region. One or more windings are arranged on at least one of the two or more planar regions for manipulating magnetic field at the vapor cell.

## Description

### FIELD

The present disclosure relates to magnetic sensors, in particular to optically pumped magnetometers.

### BACKGROUND

Optically pumped magnetometers (OPMs) are high-sensitivity quantum sensors that can take advantage of the unique vapor properties, such as alkali vapor properties, and their interaction with electromagnetic fields such as magnetic and laser fields to detect magnetic fields with unprecedented sensitivity. When compared to superconducting sensors, OPMs have strengths and weaknesses. However, they can match the sensitivity of superconducting sensors, while also working without cryogenics, making them potentially disruptive for example in the biomagnetic applications of magnetoencephalography (MEG) and magneto-cardiography (MCG). Deploying OPMs in high-end applications can be expedited by making them simultaneously sensitive, fast, with a large dynamic range, close packable, manufacturable, and reliable in large numbers.

### SUMMARY

It is an objective to provide various solutions for improved OPMs.

According to a first aspect, an optically pumped magnetometer comprises a vapor cell for optical pumping, a light source arranged for optically pumping the vapor cell, a photosensitive device arranged for sensing light from the vapor cell and a circuit board construction comprising two or more planar regions coupled to each other, indirectly or directly, through one or more flexible regions, the two or more planar regions comprising a first planar region and a second planar region. The one or more windings may thus be arranged on at least one of the two or more planar regions for manipulating magnetic field at the vapor cell. The solution allows the OPM to be constructed as a circuit-board origami enabling a close-packed construction, which can be reliably manufactured and operated. Due to the one or more flexible regions, the two or more planar regions may be folded into shape, even when the two or more planar regions and any circuit constructions therein, such as the one or more windings, are fabricated, e.g. patterned, with the two or more planar regions being in the same plane.

In an embodiment, the vapor cell is positioned intersecting an imaginary straight line from the first planar region to the second planar region. In effect, this allows the vapor cell to be positioned partially or fully between the first planar region and the second planar region, e.g. as sandwiched between said planar regions.

In an embodiment, the first planar region and the second planar region are parallel. This may be arranged by the first planar region and the second planar region being directly coupled to each other through a flexible region or the first planar region and the second planar region being indirectly coupled to each other through one or more planar regions and multiple flexible regions.

In an embodiment, the one or more windings comprise one or more first windings on the first planar region and/or the second planar region for generating a first magnetic field at the vapor cell for counteracting an external magnetic field at the vapor cell. This allows screening of the external magnetic field. The screening can be generated close to the vapor cell and thereby closely customized for the vapor cell. The first magnetic field may be generated with field components in one, two or three spatial dimensions.

In an embodiment, the one or more windings comprise one or more second windings on the first planar region and/or the second planar region for generating one or more magnetic modulation fields at the vapor cell. This allows directly improving optical pumping with magnetic modulation.

In an embodiment, the photosensitive device is arranged on a planar region of the two or more planar regions, in particular on a third planar region of the two or more planar regions. Arranging the photosensitive device on the two or more planar regions allows it to be folded into place along the two or more planar regions. Arranging the photosensitive device on the third planar region separate from the first planar region and the second planar region allows versatility in positioning the photosensitive device.

In an embodiment, the two or more planar regions are rigid. The circuit board construction can thus be provided as a rigid-flex construction such as a rigid-flex circuit board. However, the circuit board construction may also be provided with the one or more flexible regions attached to the two or more planar regions, for example by a solder connection.

In an embodiment, at least one planar region of the two or more planar regions is provided as a multi-layered circuit board. This allows versatile constructions for the OPM.

In an embodiment, the OPM comprises one or more third windings at the multi-layered circuit board of the at least one planar region of the two or more planar regions for magnetically self-shielding the OPM. The self-shielding allows prevention of crosstalk for the OPM. It also allows highly controlled manufacturing, lowered parts count and ease in assembly. The circuit board construction allows bi-planar self-shielding with the one or more third windings.

In an embodiment, the at least one planar region comprises at least two planar regions, in particular the first planar region and the second planar region. Having the one or more third windings on multiple planar regions allows self-shielding from different positions and/or orientations in three-dimensional space. In particular, it allows the one or more third windings to enclose a space, such as the space containing the vapor cell, for self-shielding. Such self-shielding can particularly effectively be performed with the one or more third windings at both the first planar region and the second planar region. The first planar region and the second planar region may then sandwich the vapor cell, as described above.

In an embodiment, the OPM comprises a preamplifier for the photosensitive device, the preamplifier being arranged on a planar region of the two or more planar regions. This allows amplification close to the vapor cell, and thereby close to the OPM signal generation. Also, as the OPM may be operated in a magnetically shielded room (MSR), having the preamplifier at the OPM allows preamplification to take place within the MSR. With this solution, the OPM may comprise separate photocurrent stray field compensation conductors, such as printed circuit board traces, to avoid crosstalk. The preamplifier at the OPM can be positioned to minimize interference and current loops can be minimized as well.

In an embodiment, the OPM comprises a reference photosensitive device arranged to receive light bypassing the vapor cell from the light source, the reference photosensitive device being arranged on a planar region of the two or more planar regions. This allows monitoring and, if necessary, controlling the operation of the light source, e.g. power level of the light source.

In an embodiment, the light source is arranged on a planar region of the two or more planar regions. Arranging the light source on the two or more planar regions allows it to be folded into place along the two or more planar regions. Further, arranging the photosensitive device on a planar region that is separate from the first planar region and the second planar region allows versatility in positioning the photosensitive device.

In an embodiment, the vapor cell is enclosed in a thermal insulator. Optical pumping may generate a considerable amount of heat and this allows restricting the amount of heat transmitted to the surroundings of the vapor cell due to optical pumping of the vapor cell. The thermal insulator may be enclosed partially or fully between the first planar region and the second planar region.

In an embodiment, the thermal insulator is aerogel for thermally insulating the vapor cell. This allows providing improved performance at lowered cost. The solution can be provided repeatably, scalably and with improved tolerancing.

It is to be understood that embodiments described above may be used in any combination with each other and the aspect described above. Several of the embodiments may be combined together to form a further embodiment.

The disclosed solutions allow the OPM 100 to be used for measuring extremely weak magnetic fields with high sensitivity and accuracy. The circuit board construction as described herein can be made without soldering, in particular hand-soldering, of connections. It can also be made without magnetic internal connectors. Parts count may also be reduced in comparison to previous solutions and the assembly can be made easier. Minimizing the number and/or size of parts and connectors becomes important as they are often magnetic and thereby disrupt sensor operation. Moreover, miniaturizing the sensor itself can be particularly important for solutions where multiple sensors are utilized, for example in imaging of brain magnetic field where a large number, e.g. hundreds, of sensors can be required close to a person's head.

The circuit board construction allows the planar parts to be folded around the vapor cell, which in turn allows the one or more windings to be brought around the vapor cell. This can be done without the two or more planar regions being separate, e.g. as separate circuit boards. The circuit board construction can be provided as one monolithic circuit board, which can have flexible and planar regions. In practice, this allows all wiring to be performed between the two or more regions by minimizing stray current loops. The two or more planar regions allows the structure to be made rigid in contrast to the construction being made of flexible support only. This allows the positioning of the one or more windings to be made exact. The circuit board construction allows a single industrially manufactured assembly to be provided including the one or more windings as rigid coils supported on the two or more planar regions coupled through the one or more flexible regions. The coils can thus be made exact.

The solution allows the one or more windings to be brought close to the vapor cell, in particular at the first planar region and/or at the second planar region. The magnetic field at the vapor cell can thus be closely controlled. The magnetic field can be manipulated with the one or more windings to minimize the external magnetic field at the vapor cell and/or maximize the magnetic field for detection at the vapor cell.

### BRIEF DESCRIPTION OF THE DRAWINGS

The accompanying drawings, which are included to provide a further understanding and constitute a part of this specification, illustrate embodiments and together with the description help to explain the principles of the invention. In the drawings:
Fig. 1 is a cross-sectional side view of an OPM according to an embodiment.
Fig. 2 illustrates an OPM according to another embodiment,
**Figs. 3a** **and** **3b** illustrate a circuit board construction of the OPM according to an embodiment in an unfolded state and in a folded state, respectively, and
**Figs. 4a** **and** **4b** illustrate a circuit board construction of the OPM according to another embodiment in an unfolded state and in a folded state, respectively.

Like references are used to designate equivalent or at least functionally equivalent parts in the accompanying drawings.

### DETAILED DESCRIPTION

The detailed description provided below in connection with the appended drawings is intended as a description of the embodiments and is not intended to represent the only forms in which the embodiment may be constructed or utilized. However, the same or equivalent functions and structures may be accomplished by different embodiments.

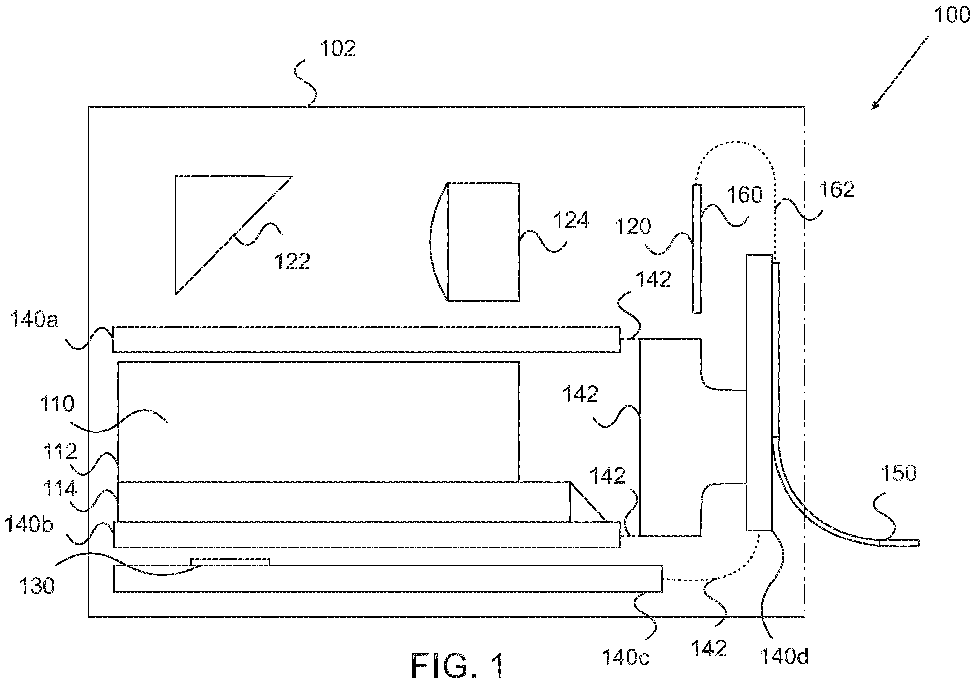

Figure 1 shows an example of an optically pumped magnetometer (OPM) 100. The OPM may comprise a vapor cell 110 (in the illustrations the vapor cell 110 is in fact within a cover enclosing the vapor cell, wherein the cover may be a thermal insulator as described below in more detail), such as an alkali vapor cell, which is arranged for optical pumping. It can contain magnetically sensitive material such as an alkali metal, e.g. rubidium or cesium, for optical pumping in vapor form. Within the vapor cell there is a measuring volume. The OPM may comprise the cover in one or more parts, for example comprising or consisting of a first part 112 and a second part 114, which may be shaped to enclose the vapor cell between them.

The OPM 100 may comprise a light source 120 for optically pumping the vapor cell 110. The light source may comprise or consist of one or more lasers such as vertical-cavity surface-emitting lasers (VCSELs). The OPM can be arranged for light 220 from the light source to be directed to the vapor cell, for example through one or more optical elements, such as one or more mirror, prisms, or lenses 122 for altering the direction of the light and/or one or more collimators 124 for collimating the light from the light source. The OPM may also comprise one or more optical devices, such as quarter-wave plates, arranged to alter the polarization of the light from the light source 120. The light source may be arranged to emit light at a wavelength that excites the magnetically sensitive material of the vapor cell, e.g. alkali atoms. The light source may thus be tuned to the resonant frequency of the magnetically sensitive material. The light source may be modulated at a modulation frequency for allowing detection of the material response, e.g. atomic response, to the magnetic field at the vapor cell. In the OPM, the transparency of the vapor cell for light can be dependent on the magnetic field at the vapor cell and thereby the magnetic field at the vapor cell can be measured by measuring the light from the vapor cell. When it is indicated here that the light from the light source is directed to the vapor cell 110, it can always be understood that it is directed to the measuring volume of the vapor cell, which allows the OPM to function as a magnetic field sensor. The measurements performed by the OPM can indicate the magnetic field, or the strength thereof in one or more dimensions, in the measurement volume.

On an optical path between the vapor cell 110 and the light source 120, there may also be a partial reflector or a beam splitter (not illustrated) for separating a part of the light, which separated light may be used for monitoring and/or controlling the output of the light source. For this purpose, the OPM 100 may comprise a reference photosensitive device such as a photodiode. The reference photosensitive device can be arranged to receive the separated light, i.e. light bypassing the vapor cell, from the light source. The reference photosensitive device may be arranged to provide information of the light for a feedback control system for controlling the light source. This allows adjusting the optical pumping with the light source to arrange conditions for sensitive magnetic field measurements. The reference photosensitive device can be arranged to be used for stabilizing the light output of the light source, e.g. output power.

The OPM 100 may comprise a photosensitive device 130, such as a photodiode, for sensing light from the vapor cell 110, which allows monitoring magnetic field at the vapor cell. The light 220 from the light source 120 can optically pump the magnetically sensitive material in the vapor cell and, since this material is magnetically sensitive, the light emerging from the vapor cell in response to the light introduced into the vapor cell is dependent on the magnetic field at the vapor cell. As the light emerging from the vapor cell can be sensed with the photosensitive device, an output of the photosensitive device can be used for determining the magnetic field at the vapor cell. The photosensitive device may be used to measure one or more property of the light from the vapor cell, such as intensity and/or power. It can thus capture changes in light intensity caused by the interaction of the magnetically sensitive material and the magnetic field at the vapor cell. The photosensitive device may be provided with a planar conductor pattern or with a meandering conductor pattern. The latter, e.g. as illustrated, allows increased sensitivity by limiting thermal noise from the conductors forming the pattern. It can also be understood as a wire pattern, for example as traces on a printed circuit board. In general, the photosensitive device can be provided as a combination of integrated electronics on the two or more planar regions 140 and coil wiring, e.g. from the meandering conductor pattern.

The OPM 100 may comprise a housing 102 for enclosing, partially or fully, any or all of the components disclosed herein. The housing may be magnetically shielded to minimize external interference from magnetic fields. However, various other magnetic shielding techniques for the OPM may be utilized as well.

Any of the components of the OPM 100 as mentioned herein may be arranged on a circuit board, such as a printed circuit board. In particular, the OPM may comprise a circuit board construction 300 comprising two or more planar regions 140 coupled to each other through one or more flexible regions 142. All of the one or more flexible regions may have a flexibility larger than the flexibility of all of the two or more planar regions to which it is coupled to. In particular, all of the one or more flexible regions may have a flexibility larger than the flexibility of any of the two or more planar regions. For example, the one or more flexible regions can be elastically deformable, in particular for folding the circuit board construction from an unfolded state to a folded state, whereas the two or more planar regions may be plastically deformable. The two or more planar regions may comprise or consist of a first planar region 140a and a second planar region 140b, but the number of planar regions may be also larger, for example, three, four or more. The two or more planar regions may be pairwise connected by a flexible region of the one or more flexible regions. The two or more planar regions can be provided as circuit board regions, for example as a part of a rigid-flex circuit board or as circuit boards connected to each other through the flexible regions. The one or more flexible regions may be part of the circuit boards, e.g. as in a rigid-flex circuit board, and/or they may be connected to the circuit boards, for example by solder connections. In general, the two or more planar regions 140, or the first planar region 140a and/or the second planar region 140b in particular, may be rigid. Any or all of the two or more planar regions 140, in particular the first planar region 140a and/or the second planar region 140b, may be provided as a multi-layered circuit board, such as a multi-layered printed circuit board.

The circuit board construction 300 can be prepared in an unfolded state and then folded into a folded state for providing the OPM 100, e.g. as illustrated in Fig. 1. The folded state is thus the operational state of the circuit board construction and any references to the OPM can be understood as referring to the OPM having the circuit board construction in its folded state unless indicated otherwise. In particular, the circuit board construction can be folded for a compact fit within the housing 102 of the OPM 100.

The OPM 100 may comprise one or more windings arranged on any or all of the two or more planar regions for manipulating magnetic field at the vapor cell. The one or more windings are thereby arranged to function as coils. The one or more windings can be printed windings on a circuit board.

The OPM 100, and the one or more windings 342, may be configured for manipulating the magnetic field at the vapor cell 110 for various reasons. For example, the magnetic field at the vapor cell may be manipulated to counteract an external magnetic field, i.e. a magnetic field that originates externally from the OPM. The OPM may thus be arranged to reduce or minimize the external magnetic field at the vapor cell. For this purpose, the one or more windings may be arranged to manipulate any or all of the three-dimensional spatial components of the magnetic field at the vapor cell, i.e. manipulating the magnetic field in one, two or three spatial dimensions. Alternatively or additionally, the magnetic field at the vapor cell may be manipulated by one or more magnetic modulation fields. Providing the one or more magnetic modulation fields allows defining one or more sensitivity axes for the OPM, and for the vapor cell. Such a magnetic modulation field may be used to measure magnetic field strength in the direction of said magnetic modulation field. Utilizing multiple magnetic modulation fields having different frequencies and/or different directions allows measuring the magnetic field at the vapor cell in different directions. However, the OPM may also be arranged for utilizing the magnetic modulation fields in only a single direction for minimizing noise. The OPM may be arranged for the external magnetic field to be counteracted with same or different windings of the one or more windings used for the magnetic modulation.

The one or more windings 342 may comprise one or more first windings, in particular on the first planar region 140a and/or the second planar region 140b, for generating a first magnetic field at the vapor cell 110 for counteracting the external magnetic field at the vapor cell. Alternatively or additionally, the one or more windings 342 may comprise one or more second windings, in particular, on the first planar region 140a and/or the second planar region 140b for generating one or more magnetic modulation fields at the vapor cell. The one or more first windings and the one or more second windings may be the same windings or different windings and the OPM 100 may be separately configured for each use.

The one or more windings 342 may comprise one or more third windings on the two or more planar regions 140, in particular on the first planar region 140a and/or the second planar region 140b, for magnetically self-shielding the OPM 100. The OPM may comprise multiple self-shielding windings of the one or more windings on a single planar region of the two or more planar regions, in particular on the first planar region or on the second planar region. Alternatively or additionally, it may comprise self-shielding windings of the one or more windings on separate planar regions of the two or more planar regions, in particular on the first planar region and/or on the second planar region. In all cases, any planar region on which the one or more third windings are, in particular the first planar region 140a and/or the second planar region 140b, may be provided as a multi-layered circuit board, on which the one or more third windings may be arranged on one or more layers, e.g. as printed winding. The one or more third windings may be arranged to mitigate crosstalk at the OPM, in particular within the housing 102 of the OPM. This can be done so that the magnetic field outside the OPM is not affected, at least substantially.

As the first planar region and the second planar region may be positioned on opposite sides of the vapor cell 110, arranging any of the one or more windings as described above on said planar regions allows effectively and compactly providing the beneficial effect of said windings, such as the magnetic modulation, the self-shielding or counteracting the external magnetic field.

The OPM 100 may be arranged for example as illustrated in Fig. 1 but various other alternatives are also possible. In particular, the vapor cell 110 may be arranged between the first planar region 140a and the second planar region 140b. The first planar region and the second planar region may be arranged so that they are parallel, as is also illustrated. While the vapor cell may be fully between the first planar region and the second planar region, it may also be partially between the first planar region and the second planar region. In particular, the vapor cell may be positioned intersecting an imaginary straight line from the first planar region to the second planar region, which applies when the first planar region and the second planar region are parallel or non-parallel, e.g. at an angle or even perpendicular, with respect to each other. The vapor 110 cell may be arranged on the first planar region 140a or the second planar region 140b so that it is supported, indirectly or directly, by said planar region.

The light source 120 may be arranged on one of the two or more planar regions 140 or it may be supported separately from any of the planar regions. In particular, it may be provided on a circuit board 160 of the OPM, such as a printed circuit board, that is separate from the circuit board construction of the OPM 100. The circuit board may be connected to the circuit board construction, e.g. to the two or more planar regions 140 through a connector 162 such as a flexible connector, e.g. a soldered flex connector. As a specific example, when the circuit board construction is provided as a rigid-flex construction such as a rigid-flex circuit board, the light source may be provided on a separate circuit board 160 from the rigid-flex construction/circuit board, e.g. as described above. The OPM 100 may be arranged for the light 220 from the light source 120 to be directed along an optical path that is perpendicular to the first planar region 140a and/or the second planar region 140b for entering the vapor cell 110. Alternatively or additionally, the OPM 100 may be arranged for the light from the vapor cell 110 to be directed along an optical path that is perpendicular to the first planar region 140a and/or the second planar region 140b for exiting the vapor cell 110 and, optionally, entering the photosensitive device 130.

The OPM 100 may comprise a third planar region 140c, which may also be parallel with the first planar region and/or the second planar region, e.g. as illustrated. While the photosensitive device 130 may be arranged on any of the two or more planar regions 140, it may be in particular arranged on the third planar region 140c. It may thus be arranged below the first planar region 140a and/or the second planar 140b region.

The OPM 100 may be arranged for the light 220 from the light source 120 exiting parallel to the first planar region 140a and/or the second planar region 140b, e.g. as illustrated. This allows a compact design. The light from the light source may then be redirected by one or more optical elements 122, such as prisms, for entering the vapor cell 110. The OPM may be arranged for the light from the light source to enter the vapor cell through the first planar region or the second planar region, for example through a first hole 340, such as a through-hole, in said planar region. Alternatively or additionally, the OPM may be arranged for the light from the vapor cell to exit the vapor cell through the first planar region or the second planar region, for example through a second hole, such as a through-hole, in said planar region. The first hole 340 and the second hole may be aligned with respect to each other so that an optical path from the first hole 340 to the second hole is perpendicular with respect to the first planar region and/or the second planar region. The reference photosensitive device mentioned above may be arranged on one of the two or more planar regions 140. This may be the same planar region on which the light source 120 or the photosensitive device 130 is positioned on, for example the third planar region 140c.

The OPM 100 may comprise a preamplifier (not illustrated) for the photosensitive device 130. This allows the output of the photosensitive device to be amplified already at the OPM, which is notable as the output may in many cases be very low. The preamplifier can be arranged on a planar region of the two or more planar regions 140, in particular on the same planar region as the photosensitive device, e.g. on the third planar region 140c.

The OPM 100, or the vapor cell 110 in particular, may heat up to over 100 degrees Celsius during operation, for example to 150-180 degrees Celsius or more. The OPM may thus comprise a thermal insulator partially or fully enclosing the vapor cell 110. The vapor cell may be provided on a support, such as a circuit board, within the thermal insulator. The thermal insulator is arranged for thermally insulating the vapor cell, for example on one or more sides of the vapor cell or on all sides of the vapor cell. The thermal insulator may comprise or consist of a ceramic, such as a low temperature co-fired ceramic, aerogel and/or a superinsulator. The ceramic solution can provide very good insulation performance and good tolerancing. The aerogel may be provided as machined aerogel. It may thus be like hard foam. Similarly, the superinsulator may be provided as machined superinsulator. The machined solutions contrast to cast or molded solutions and they may be handled like lightweight engineering plastic. The thermal insulator can be arranged for providing vacuum insulation around the vapor cell. The thermal insulator may be arranged, at least in part, between the vapor cell and the first planar region 140a and/or between the vapor cell and the second planar region 140b. It may be arranged on the first planar region or the second planar region so that it is supported, indirectly or directly, by said planar region.

The OPM 100 may comprise one or more signal and/or power connections 150. An interface for the one or more signal and/or power connections may be arranged on the two or more planar regions, for example on a fourth planar region 140d. It may be arranged as a centralized interface. The preamplifier as described above may also be arranged on the fourth planar region allowing it to be brought away from the vapor cell 110 for reducing noise.

As illustrated in Fig. 1, the first planar region 140a, the second planar region 140b and the third planar region 140c may each be pairwise coupled to the fourth planar region 140d through flexible regions 142. The first, second and third planar regions are parallel while the fourth planar region is perpendicular to the other three.

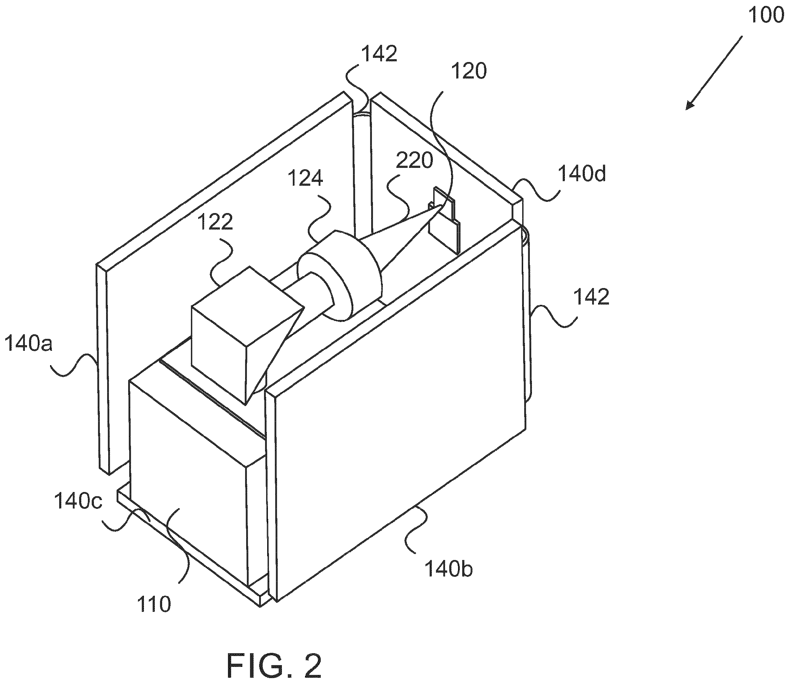

Fig. 2 illustrates one example of the OPM 100. The OPM may include any of the features described above, such as the housing 102, even if not specifically illustrated. Similarly, any features illustrated with reference to Fig. 2 may be utilized together with any other examples.

As illustrated here, the OPM 100 may have the first planar region 140a and the second planar region 140b arranged perpendicular with respect to the third planar region 140c. The vapor cell 110 may be positioned on the third planar region and it may be supported by the third planar region. The vapor cell may still be arranged between the first planar region and the second planar region. The light source 120 may be arranged on the two or more planar regions 140, or on the fourth planar region 140d in particular.

Again, the first planar region 140a, the second planar region 140b and the third planar region 140c may each be pairwise coupled to the fourth planar region 140 through the flexible regions 142. The first and second planar regions are parallel while the third planar region and the fourth planar region are each perpendicular to the other three.

Accordingly, the OPM 100 may be provided with all the two or more planar regions 140 parallel (as the fourth planar region is not necessarily required), the two or more planar regions forming two groups of one or more planar regions being parallel with the two groups being perpendicular to each other or the two or more planar regions forming three groups of one or more planar regions being parallel with the three groups being perpendicular to each other.

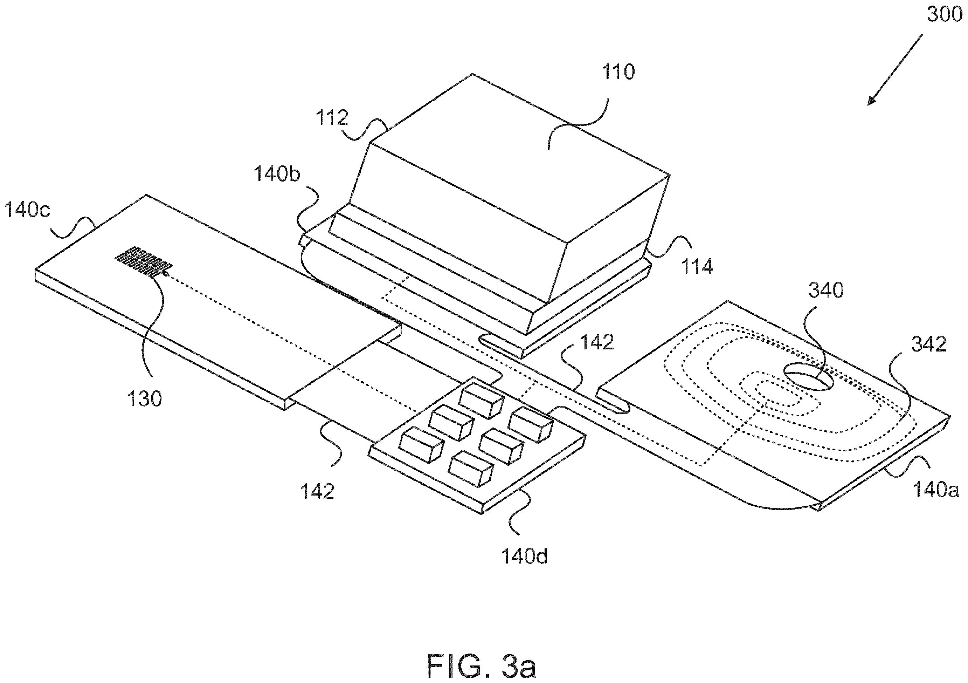

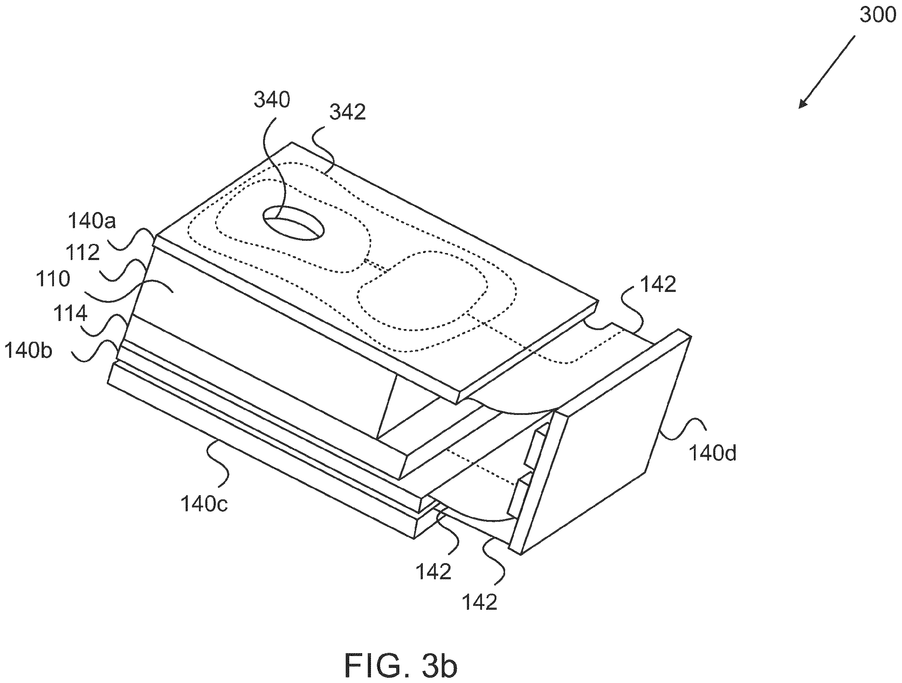

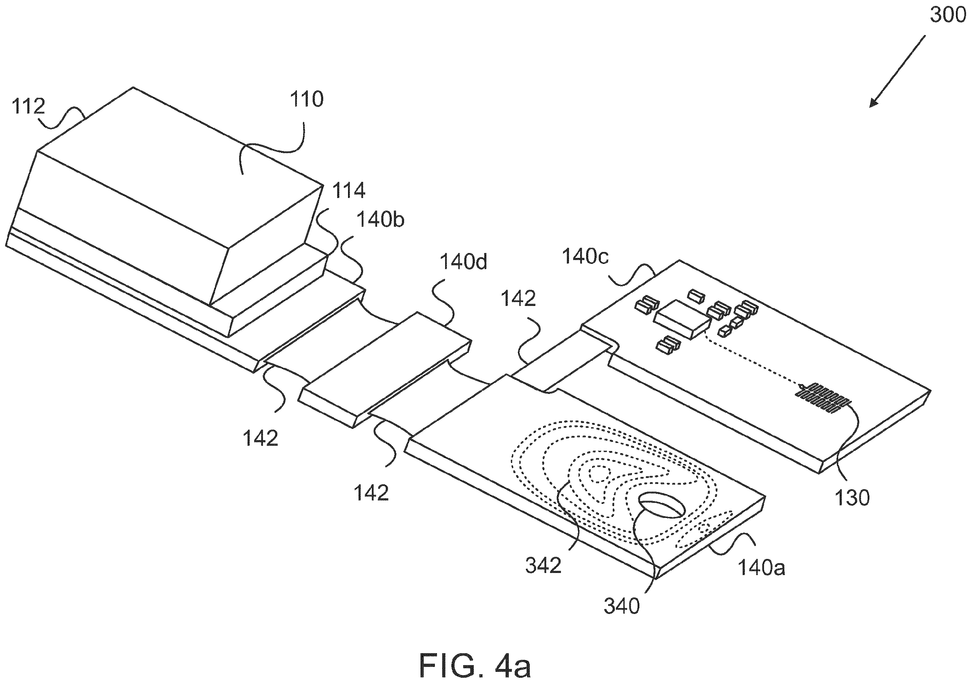

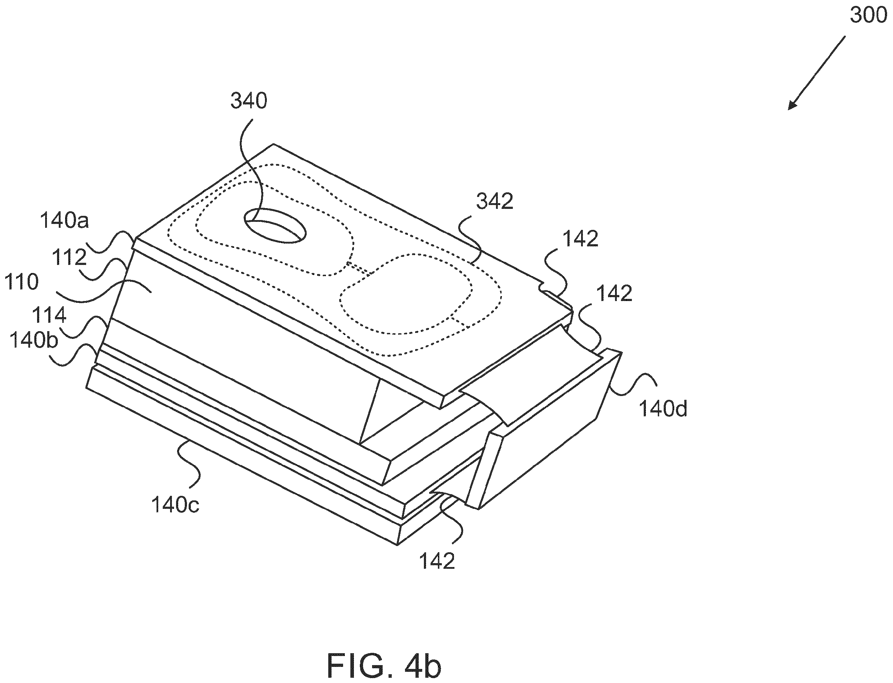

Figs. 3a-b and 4a-b illustrate two examples of the circuit board construction 300 in an unfolded state (Figs. 3a and 4a) and in a folded state (Figs. 3b and 4b). The first example corresponds to the circuit board construction in Fig.1 in terms of relative positioning of the planar regions 140 and in terms of coupling of the planar regions 140 through the flexible regions 142. The second example is a variation of the first example, where the relative positioning of the planar regions 140 remains as in the first example but the coupling of the planar regions 140 through the flexible regions 142 is slightly changed for the coupling of the planar regions 140 to each other through the flexible regions 142. The examples also illustrate some possibilities for the first hole 340 and the one or more windings 342.

The different functions discussed herein may be performed in a different order and/or concurrently with each other.

Any range or value given herein may be extended or altered without losing the effect sought, unless indicated otherwise. Also any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the scope of this specification.

## Claims

1. An optically pumped magnetometer (OPM) comprising:
- a vapor cell for optical pumping;
- a light source arranged for optically pumping the vapor cell;
- a photosensitive device arranged for sensing light from the vapor cell; and
- a circuit board construction comprising two or more planar regions coupled to each other through one or more flexible regions, the two or more planar regions comprising a first planar region and a second planar region;
wherein one or more windings are arranged on at least one of the two or more planar regions for manipulating magnetic field at the vapor cell.

2. The optically pumped magnetometer according to claim 1, wherein the vapor cell is positioned intersecting an imaginary straight line from the first planar region to the second planar region.

3. The optically pumped magnetometer according to claim 1 or 2, wherein the first planar region and the second planar region are parallel.

4. The optically pumped magnetometer according to any preceding claim, wherein the one or more windings comprise one or more first windings on the first planar region and/or the second planar region for generating a first magnetic field at the vapor cell for counteracting an external magnetic field at the vapor cell.

5. The optically pumped magnetometer according to any preceding claim, wherein the one or more windings comprise one or more second windings on the first planar region and/or the second planar region for generating one or more magnetic modulation fields at the vapor cell.

6. The optically pumped magnetometer according to any preceding claim, wherein the photosensitive device is arranged on a planar region of the two or more planar regions, in particular on a third planar region of the two or more planar regions.

7. The optically pumped magnetometer according to any preceding claim, wherein the two or more planar regions are rigid.

8. The optically pumped magnetometer according to any preceding claim, wherein at least one planar region of the two or more planar regions is provided as a multi-layered circuit board.

9. The optically pumped magnetometer according to claim 8, comprising one or more third windings at the multi-layered circuit board of the at least one planar region of the two or more planar regions for magnetically self-shielding the OPM.

10. The optically pumped magnetometer according to claim 9, wherein the at least one planar region comprises at least two planar regions, in particular the first planar region and the second planar region.

11. The optically pumped magnetometer according to any preceding claim, comprising a preamplifier for the photosensitive device, the preamplifier being arranged on a planar region of the two or more planar regions.

12. The optically pumped magnetometer according to any preceding claim, comprising a reference photosensitive device arranged to receive light bypassing the vapor cell from the light source, the reference photosensitive device being arranged on a planar region of the two or more planar regions.

13. The optically pumped magnetometer according to any preceding claim, wherein the light source is arranged on a planar region of the two or more planar regions.

14. The optically pumped magnetometer according to any preceding claim, wherein the vapor cell is enclosed in a thermal insulator.

15. The optically pumped magnetometer according to claim 14, wherein the thermal insulator is aerogel for thermally insulating the vapor cell.
